# EUROPEAN PATENT APPLICATION

(11) **EP 4 600 859 A1**
(43) Date of publication of application: **13.08.2025**
(21) Application number: 25156654.3
(22) Date of filing: 07.02.2025
(51) Int. Cl.: G06F 30/17, G06F 30/12, G06T 19/20, G06T 13/00

(54) **AUTOMATIC CREATION OF MODEL-BASED DEFINITION DIMENSIONS USING SKETCH DIMENSIONS**

(30) Priority: 09.02.2024 IN 202411008869
(71) Applicant: Dassault Systemes SolidWorks Corporation, Waltham, MA 02451-1223 (US)
(72) Inventor: Kulkarni, Nikhil, Waltham, 02451 (US); Jarvinen, Todd, Waltham, 02451 (US); Saha, Saurav, Waltham, 02451 (US); Venkatesh, Pruthvi, Waltham, 02451 (US)
(74) Representative: Bandpay & Greuter

(57) **Abstract**

A computer-based method is disclosed automatically creating one or more model-based definition (MBD) dimensions for a three-dimensional model based on one or more sketch dimensions. The method includes enabling a user to select dimensional information from a sketch to be designated as critical sketch dimensional information, designating the selected dimensional information from the sketch as critical sketch dimensional information, mapping the critical sketch dimensional information to a related face of a 3D model derived from the sketch, and executing a dimensioning tool to annotate other portions of the 3D model with product manufacturing information (PMI) while automatically incorporating dimensional information based on the critical sketch dimensional information to the related face in the 3D model for MBD.

## Description

### FIELD OF THE INVENTION

This disclosure relates to the field of computer-implemented design and modeling, and more particularly, relates to the automatic creation of model-based definition (MBD) dimensions using sketch dimensions in a computer implemented environment.

### BACKGROUND

Some computer-aided design (CAD) software allows users to sketch two-dimensional (2D) drawings and to construct and manipulate complex three-dimensional (3D) models. In SOLIDWORKS^{®} software, for example, sketching tools are provided that enable users to sketch geometric entities, such as rectangles and circles and feature tools are provided that enable users to create features, which are shapes that individually form or may be combined to form a model of a real world object to be manufactured. Some features originate from sketches. Some CAD software also provides access to model based definition (MBD) functionalities that enable users to define, organize, and publish 3D product and manufacturing information (PMI), including dimensional and tolerance information for 3D model data in industry standard file formats.

### SUMMARY OF THE INVENTION

In one aspect, a computer-based method is disclosed that entails automatically creating one or more model-based definition (MBD) dimensions for a three-dimensional model based on one or more sketch dimensions (e.g., dimensions or dimensions and associated tolerances, etc.). The method includes enabling a user to select dimensional information from a sketch to be designated as critical sketch dimensional information, designating the selected dimensional information from the sketch as critical sketch dimensional information, mapping the critical sketch dimensional information to a related face of a 3D model derived from the sketch, and executing a dimensioning tool to annotate other portions of the 3D model with product manufacturing information (PMI) while automatically incorporating dimensional information based on the critical sketch dimensional information to the related face in the 3D model for MBD.

In another aspect, a system is disclosed for automatically creating one or more model-based definition (MBD) dimensions for a three-dimensional model based on one or more sketch dimensions (e.g., a model-based definition (MBD) dimension using a sketch dimension). The system includes a computer system with a computer processor, and computer-based memory operatively coupled to the computer processor. The computer-based memory stores computer-readable instructions that, when executed by the computer processor, cause the computer system to automatically create one of the model-based definition (MBD) dimensions using a sketch dimension in accordance with a process that includes: enabling a user to select dimensional information from a sketch to be designated as critical sketch dimensional information, designating the selected dimensional information from the sketch as critical sketch dimensional information, mapping the critical sketch dimensional information to a related face of a 3D model derived from the sketch, and executing a dimensioning tool to annotate other portions of the 3D model with product manufacturing information (PMI) while automatically incorporating dimensional information based on the critical sketch dimensional information to the related face in the 3D model for MBD. In some implementations, the system includes a real-world machine (e.g., a CNC machine) coupled to the computer system. In such implementations the computer system may be configured to output a file (e.g., produced by a computer-aided manufacturing (CAM) program operating on the computer system) to the real-world machine that the real-world machine is configured to execute for automated manufacturing of the product represented by the 3D model for MBD.

In yet another aspect, a non-transitory computer readable medium is disclosed that has stored thereon computer-readable instructions that, when executed by a computer-based processor, cause the computer-based processor to automatically create a model-based definition (MBD) dimension using a sketch dimension, via a process that includes: enabling a user to select dimensional information from a sketch to be designated as critical sketch dimensional information, designating the selected dimensional information from the sketch as critical sketch dimensional information, mapping the critical sketch dimensional information to a related face of a 3D model derived from the sketch, and executing a dimensioning tool to annotate other portions of the 3D model with product manufacturing information (PMI) while automatically incorporating dimensional information based on the critical sketch dimensional information to the related face in the 3D model for MBD.

In accordance with another aspect, there is provided a computer program product configured to be operable to automatically creating one or more model-based definition (MBD) dimensions for a three-dimensional model for MBD based on one or more sketch dimensions. The method performed by a computer executing said computer program product includes enabling a user to select dimensional information from a sketch to be designated as critical sketch dimensional information, designating the selected dimensional information from the sketch as critical sketch dimensional information, mapping the critical sketch dimensional information to a related face of a 3D model derived from the sketch, and executing a dimensioning tool to annotate other portions of the 3D model with product manufacturing information (PMI) while automatically incorporating dimensional information based on the critical sketch dimensional information to the related face in the 3D model for MBD. In some implementations, the computer program product may be provided on a carrier wave, for example as a software-implemented invention supplied via the Internet.

In some implementations, one or more of the following advantages are present.

For example, the systems and techniques disclosed herein automate the addition of 3D PMI in MBD. This may simplify and accelerate product design processes and improve reliability in product design processes, by reducing the likelihood of human error. The resulting MBD models can be used directly in manufacturing a designed object and can also be used in connection with quality assurance. In a typical implementation, the systems and techniques disclosed herein provide a way of reusing dimensional information entered into a sketch or created by the application of feature functionalities to produce MBD dimensional information that is fully semantic and graphical in nature. This MBD dimensional information typically has the precise information necessary for manufacturing as prescribed by the National Institute for Standards and Technology (NIST). These systems and techniques are expected to save time and improve efficiency in designers and/or design teams. These systems and techniques also provide designers with the ability to control which dimensional information, for example, is to be automatically populated into a 3D MBD model from an associated sketch. Moreover, there is typically a 1:1 mapping of dimensions to faces in accordance with the systems and techniques disclosed herein.

Additionally, there is an increasing number of software applications that can automate manufacturing processes based on 3D annotations and PMI integrated into 3D CAD models for MBD. These applications include Computer Aided Manufacturing (CAM), Coordinate Measuring Machines (CMM) for inspection, cost estimations, tolerance stack-up optimizations, Computer-Aided Process Planning (CAPP), etc. Manufacturing procedure time can be shortened from hours to minutes due to such automations. However, these valuable automations can be rendered unfeasible if semantic meanings of the 3D annotations are lost when importing a CAD model from one CAD format to another. Implementations of the systems and techniques disclosed herein help avoid such potential shortcomings.

Other features and advantages will be apparent from the description and drawings, and from the claims.

### BRIEF DESCRIPTION OF THE DRAWINGS

FIG. 1 is an image of an exemplary computer-generated sketch with dimensional information and data associated therewith.
FIG. 2. is an image of an exemplary computer-generated 3D shape created by applying an extrude feature to the sketch of FIG. 1 and data associated therewith.
FIG. 3 is a schematic representation of an example of a computer configured to implement functionalities disclosed herein.
FIG. 4 is a schematic representation of an example of components in a system configured to implement functionalities disclosed herein.
FIG. 5 is a flowchart representing an exemplary process for creating a three dimensional (3D) model for model-based definition (MBD) leveraging dimensional information designated as critical in a sketch and manufacturing the object.
FIG. 6 is a flowchart representing an exemplary process for mapping selected dimensional information designated as critical to related faces of a 3D model to facilitate the creation of a 3D model for MBD.
FIG. 7A is an example of a computer-generated sketch on a display with dimensional information.
FIG. 7B is the sketch with dimensions from FIG. 5A, with a dialogue box that enables users to designate certain dimensional information as critical.
FIG. 7C is a computer-generated 3D model derived from the sketch of FIG. 1.
FIG. 7D shows the 3D model of FIG. 5C with a dialog box for identifying critical dimensional information.

Like reference characters refer to like elements.

### DETAILED DESCRIPTION

This document uses a variety of terminology to describe its inventive concepts. This terminology should be given its ordinary meaning and, unless otherwise indicated, may be understood as having meanings that are consistent with what follows.

For example, computer-aided design (CAD) software allows a user to construct and manipulate complex three-dimensional (3D) models. Solidworks^{®} computer software and Catia^{®} computer software, both of which are available from Dassault Systèmes SolidWorks Corporation, the applicant of the current application, are examples of CAD software that may be used, for example, to construct and manipulate complex three-dimensional (3D) models. A "design engineer" is a typical user of a 3D CAD system. The design engineer typically designs physical and aesthetic aspects of 3D models and may be skilled in 3D modeling techniques. The design engineer typically creates parts and may assemble certain parts into a subassembly. A subassembly may also consist of other subassemblies. An assembly may be designed using parts and subassemblies. Parts and subassemblies may be collectively referred to as components. The phrase "design engineer" used herein should be construed broadly to include any one or more human users of a computer or computer system implementing the techniques disclosed herein.

A dimensioning tool is a computer software component that enables users to define, organize, and publish 3D product and manufacturing information (PMI), including dimensional and tolerance information for 3D model data in industry standard file formats for model based definition (MBD). An existing example of a dimensioning tool is the DimXpert^{™} tool, which is built into SOLIDWORKS^{®} and enables users quickly and easily dimension models in 3D space. The DimXpert^{™} tool allows us to communicate sizes, locations, and tolerances so that other users can easily understand and manufacture our parts. More specifically, the DimXpert^{™} tool facilitates the application of datum, dimensions, tolerancing, and GD&T information directly into a 3D CAD model. DimXpert for parts is a set of tools that enable users to apply dimensions and tolerances to parts according to the requirements of ASME Y14.41-2003 and ISO 16792:2006. DimXpert tools allows users to insert dimensions and/or tolerances manually or automatically (e.g., from a database).

A features tool is a computer software component that facilitates the application of surface and/or manufacturing features to a sketch or 3D model. The SOLIDWORKS^{®} software application includes a features tool for DimXpert^{™} that supports manufacturing features including boss, chamfer, cone, cylinder, discrete feature types, fillet, counterbore hole, countersink hole, simple hole, etc. When developing models using the SOLIDWORKS^{®} software application, for example, a user may sketch one or more geometric entities, such as rectangles and circles, that serve as the basis for one or more solid features such as extrusions, revolves, and cuts. Traditionally, a design procedure in SOLIDWORKS^{®}, from sketch through model to drawing, would have been as follows. In a part document, the user would open a sketch and sketch an entity, such as a rectangle, approximately. The user may add dimensions to the sketch if desired. The user may then extrude the sketch to form a 3D solid base feature, which becomes a part or a basis of a part. The user may then open a drawing, insert the part as a 2D standard image with multiple views (e.g., front, top, side) and then insert dimensions. A solid modeling system, for example, may be a feature-based 3D CAD system wherein a part is constructed using various features. Examples of features include bosses, fillets, chamfers, cuts, holes, shells, lofts, and sweeps. CAD systems store the contents of parts, subassemblies, and assemblies in a data file. In addition to features, the contents of CAD data files may include design profiles, layouts, internal components (e.g., bodies), and graphical entities.

A sketching tool is a computer software component that enables users to produce 2D images (sketches) that can form the basis for a 3D model. Sketches can be created on any one or more planes including, for example, a front plane, a top plane, a right plane, or a created plane. The SOLIDWORKS^{®} software programs includes a sketching tool that enables users to perform these functionalities. Sketching in SOLIDWORKS^{®} is the basis for creating features. Features are the basis for creating parts, which can be put together into assemblies. In the SOLIDWORKS^{®} software program, a user may create and/or edit sketches using, for example, sketch entities or a sketch tool, planes, or extruded or revolved bosses/bases. Users may add dimensions to sketches. However, features can be created from sketches with or without dimensions.

Model based definition (MBD) refers to the practice of using 3D models within 3D CAD software to define (provide specifications for) individual components and/or product assemblies. The types of information included may include geometric dimensioning and tolerancing (GD&T), component level materials, assembly level bills of materials, engineering configurations, design intent, etc. By contrast, other methodologies have historically required accompanying use of 2D engineering drawings to provide such details. Some 3D CAD applications allow for inserting engineering information such as dimensions, GD&T, notes and other product details within a 3D digital data set for a component and/or assembly. MBD uses such capabilities to establish the 3D digital data set as the source of these specifications and design authority for the product. The 3D digital data set may contain enough information to manufacture and inspect the product without the need for engineering drawings, which traditionally include such information. In many instances, using this information from 3D digital data set (e.g., the solid model) allows for rapid prototyping of a product via various processes, such as 3D printing. In some instances, a manufacturer may be able to feed 3D digital data directly into one or more manufacturing devices, such as computer numerical control (CNC) machines, to manufacture the final product. SOLIDWORKS MBD^{™} is an example of a computer software program that gives users access to MBD. In a typical implementation, it helps users define, organize, and publish 3D PMI, including 3D model data, such a dimensions and tolerances, in industry standard file formats. Moreover, SOLIDWORKS MBD operates within the SOLIDWORKS environment with its own CommandManager, and supports native SOLIDWORKS 3D part and assembly data, such as configurations, constraints, and PMI.

The phrase "processor" (or the like refers) to any one or more computer-based processing devices. A computer-based processing device is a physical component (e.g., a CPU) that can perform computer functionalities by executing computer-readable instructions stored in memory. If there is more than one computer-based processing device or processor cores, they can be contained in a single physical device (e.g., in a single a computer or server) or distributed across multiple physical devices that may be located, for example, in more than one physical location or facility.

The phrase "memory" (or the like) refers to any one or more computer-based memory devices. A computer-based memory device is a physical component that can store computer-readable instructions that, when executed by a processor, results in the processor performing associated computer functionalities. If there is more than one computer-based memory device, they can be contained in a single physical device (e.g., a computer or server) or distributed across multiple physical devices that may be in more than one physical location or facility.

The phrase "computer numerical control" or "CNC" refers to the automatic control of one or more machining tools, such as lathes, drills, grinders, routers, mills, 3D printers, etc. by means of a computer. A "CNC machine" is a machine that includes one or more such machining tools and that is configured to process a piece of material (e.g., metal, plastic, ceramic, wood, composite, etc.) to meet specifications by following coded programmed instructions and without a manual operator directly controlling the machining operation. Instructions may be delivered to a CNC machine from a computer in the form of a sequential program of machine control instructions, and then executed by the CNC machine. In some instances, the program may have been generated by or from CAD software and/or computer-aided manufacturing ("CAM") software (e.g., based on a model that was generated using the CAD/CAM software). In such instances, the object's mechanical dimensions, for example, may have been defined using the CAD software and then translated into manufacturing directives (e.g., by corresponding CAM software). The resulting directives may be utilized as (or to provide) CNC-compatible commands necessary for a particular CNC machine to perform manufacturing operations in connection with producing a real-world version of the object. The CNC-compatible commands may be loaded into and executed by the CNC machine to perform real-world manufacturing operations (e.g., subtractive operations) on one or more pieces of material (e.g., metal, plastic, ceramic, wood, composite, etc.).

A number of terms and phrases particular to CAD programs are used herein. Unless otherwise indicated, these terms and phrases should have meanings that correspond with the following. For example, the phrase "annotation" refers to a callout to convey product and manufacturing requirements and instructions, such as notes, datum symbols, geometric dimensions and tolerances, weld symbols, surface finishes, etc. An annotation can be attached to and associated with a 3D model, for example, or displayed separately from a 3D model, commonly referred to as a 3D annotation. A 3D annotation can be displayed graphically for human eye readings and can also represent semantic meanings beyond the graphical presentation. The phrase "assembly" refers to a document in which parts, features, and other assemblies (subassemblies) are mated together. Parts and subassemblies can exist in documents separate from the assembly. For example, in an assembly, a piston can be mated to other parts, such as a connecting rod or cylinder. This assembly can then be used as a subassembly in an assembly of an engine. The term "component," when used in reference to a CAD design, refers to any part or subassembly within an assembly. The term "datum" refers to a theoretical exact plane, axis, or point location to which GD&T or dimensional tolerances, for example, reference. An "edge," as used herein, refers to a single outside boundary of a feature. The term "entity" refers to a discrete element, such a face, edge, vertex, etc. The term "face" refers to a selectable area (planar or otherwise) of a model or surface with boundaries that help define the shape of the model or surface. For example, a rectangular solid has six faces, and a cylindrical solid has three faces. The term "feature" refers to an individual shape that, combined with other features, makes up a part or assembly. The term "part" refers to a single 3D object made up of features. A part can include multiple bodies. A part can become a component in an assembly. Examples of parts include, for example, a bolt, pin, and plate. The term "plane" refers to a flat construction geometry. The term "point" refers to a singular location in a 3D model or a sketch. The term "subassembly" refers to an assembly that is part of a larger assembly. For example, a steering mechanism of a car is a subassembly of the car. The term "surface" refers to a zero-thickness planar or 3D entity with edge boundaries. The term "vertex" refers to a point at which two or more edges intersect. Vertices can be selected for sketching, dimensioning, and many other CAD operations.

### Prior Technologies are Distinct.

With MBD, users and product development and manufacturing processes have relied on PMI in a 3D model to produce and inspect parts. The PMI typically includes valuable data required for manufacturing in both semantic and graphical form. Moreover, dimensions on the model in MBD, for example, typically correspond to dimensions that can be read by CNC machines through a neutral file such as STEP AP 242. SOLIDWORKS software, for example, enables users to add PMI to a 3D model by defining it manually and individually in the 3D model directly or by using an auto dimensioning tool. Adding dimensions manually and individually is time consuming, cumbersome, repetitive, and susceptible to human error. With auto dimensioning, the user cannot control the dimensions which will be created. No prior approach enables the reuse of existing data that already was available from sketching or applying a feature (e.g., boss, cut, hole, etc.) to define Product Manufacturing Information on a 3D CAD model; nor do any approaches provide a 1:1 mapping of PMI such as dimensional information on a 3D model to corresponding dimensional information from a sketch. In various implementations, the systems and techniques disclosed herein provide technical solutions to these, and potentially other, technical problems in a CAD software environment, particularly for MBD.

### Technical Disclosure

Developing 3D CAD models for MBD typically starts with creating one or more sketches using a computer-based sketching application. During the sketching period, dimensional information, such as dimensions and associated tolerances, may be entered by the user into the sketch. Some of the dimensional information, at these early stages, may be considered critical. Critical dimensional information refers generally to information, such as dimensions and tolerances, provided in a sketch that the user wants to automatically transfer into a 3D model for MBD that derives from the sketch. Moreover, in some implementations, even though other early stage dimensional information placed into a sketch may be expected to change as the design evolves, critical dimensional information may be expected to remain as is, even as the design evolves.

In a typical implementation, a sketch by created by applying one or more sketch entities to a graphics area of a user interface in a CAD program. Typically, the sketch entities are made up of individual 2D sketch elements (e.g., lines, curves, etc.) and placed into the graphics area within a coordinate system that is defined by and includes a visual representation of a coordinate symbol that indicates the orientation of the axes (e.g., x and y axes) of the coordinate system. In a typical implementations, each sketch element is assigned a unique identifier when the sketch element is created. Each unique identifier is stored in memory in logical association with its associated sketch element. Moreover, in some implementations, each sketch element may be stored in memory in logical association with its associated orientation relative to the coordinate system.

Dimensional information (e.g., dimensions and tolerances) may be added to a sketch. Each item of dimensional information typically has a dimensional value and an associated tolerance (e.g., 100 millimeters +/- 1 millimeter), and has a reference direction (e.g., along an x-axis, along a y-axis, or at some angle relative to the x or y axis) based on its orientation within the coordinate system of the graphics area. In a typical implementation, each dimensional value and associated tolerance is saved in memory as dimensional information together and in logical association with its associated reference direction.

In a typical implementation, each sketch may be saved in memory together with its geometry (its sketch entities), unique identifiers and/or orientation for any elements of the sketch entities, dimensional information (e.g., dimensions and tolerances) added to the sketch, and reference directions for the dimensional information.

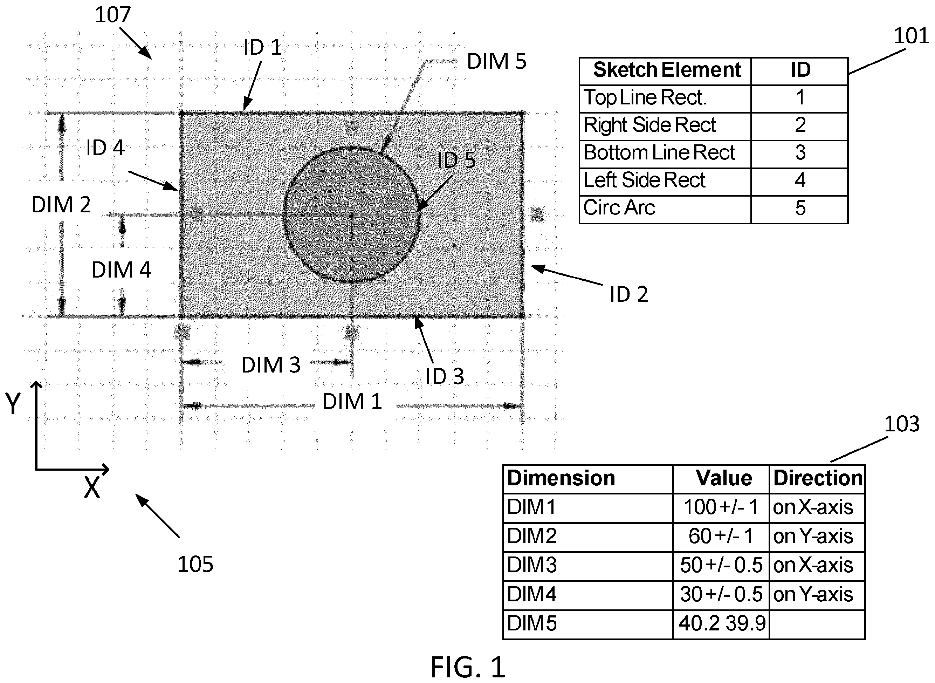

FIG. 1 is a schematic representation of a sketch 107 that may be created using a sketch functionality in a CAD program, for example, and saved, together with the data also shown in FIG. 1. The sketch includes two sketch entities: a circle and a rectangle surrounding the circle. The rectangular sketch entity has four sketch elements: a top line, a right side line, a bottom line, and a left side. The circular sketch entity has one sketch element: the circular arc. As indicated in data table 101 (which may be stored in memory in association with the illustrated sketch), each sketch element is assigned a unique identifier, which, for simplicity purposes are numbered one through five in the illustrated example. More specifically, in the illustrated example, the rectangle top line sketch element is assigned identifier one, the rectangle right side sketch element is assigned identifier two, the rectangle bottom line sketch element is assigned identifier three, the rectangle bottom line sketch element is assigned identifier three, the rectangle left side sketch element is assigned identifier four, and the circular arc sketch element is assigned identifier five. In a typical implementation, the data in data table 101 would be stored in memory together with the sketch itself, which may be displayed in a graphics areas of a CAD program's user interface.

The sketch 107 also has dimensional information (e.g., dimensions and associated tolerances) attached to it. In a typical implementation, the dimensional information will have been added by a user as the sketch is being created. The dimensional information in the illustrated implementation includes DIM 1, DIM 2, DIM 3, DIM 4, and DIM 5. DIM 1 represents a dimension (and tolerance) between the left side of the rectangle (ID 4) and the right side of the rectangle (ID 2). DIM 2 represents a dimension (and tolerance) between the bottom line of the rectangle (ID 3) and the top line of the rectangle (ID 1). DIM 3 represents a dimension (and tolerance) between the left side of the rectangle (ID 4) and a center of circle (ID 5). DIM 4 represents a dimension (and tolerance) between the bottom line of the rectangle (ID 3) and the center of the circle (ID 5). Each dimension has a value (e.g., assigned by the user) and a direction relative to the axes of the coordinate system, represented by 2D coordinate symbol 105, which is displayed in the graphics area of the CAD system's user interface as well. More specifically, and as reflected in data table 103 (which may be stored in memory in association with the illustrated sketch), dimension DIM1 has a value of 100 +/- 1, dimension DIM2 has a value of 60 +/- 1, dimension DIM3 has a value of 50 +/- 0.5, dimension DIM4 has a value of 30 +/- 0.5, and dimension DIM5 has a value between 40.2 and 39.9. In a typical implementation, these values would represent units of distance (e.g., millimeters, inches, etc.). Additionally, and as reflected in data table 103, dimensions DIM1 and DIM3 are oriented on the x-axis, whereas dimensions DIM2 and DIM4 are oriented on the y-axis. In a typical implementation, the data in data table 103 would be stored in memory together with the sketch itself, which may be displayed in a graphics areas of a CAD program's user interface, and with the data in data table 101.

Once a sketch has been started, feature functionalities, such as extruding, may be applied to the sketch to add one or more features to the sketch. Each feature functionality applied to a sketch may change the associated image in ways that create faces, to which additional dimensional information may be added (e.g., by a user specifying the new dimensional information for the features being added). An extrude feature, for example, may be applied to the sketch 107 in FIG. 1 to effectively converting the image into a 3D image, thereby introducing a thickness to the original 2D sketch that may be assigned dimensional information associated with the added thickness (e.g., a dimension value and associated tolerance). Once a 2D sketch has been extended beyond its original 2D plane (e.g., by extruding in a direction along the z-axis), the resulting image comprises faces and edges, and is no longer made up of sketch entities.

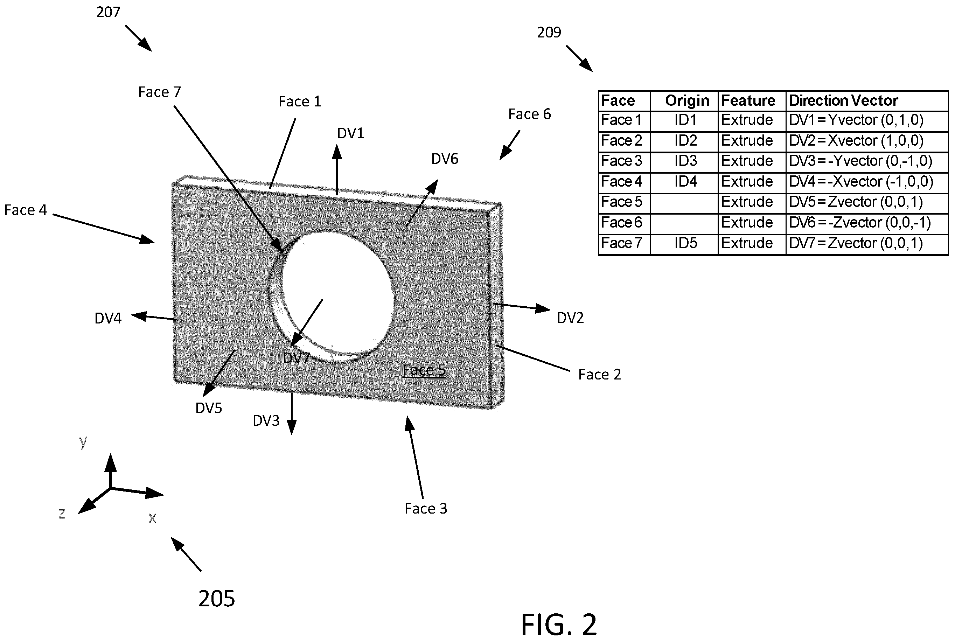

FIG. 2 shows an example of a 3D shape 207 produced by applying an extrude function to the sketch of FIG. 1. The illustrated shape 207 has seven faces: face 1, face 2, face 3, face 4, face 5, face 6, and face 7, which collectively form a rectangular cuboid with a circular cut through the rectangular cuboid.

Each face in the illustrated shape 207 has an associated direction vector DV1, DV2, DV3, DV4, DV5, DV6, DV7, respectively. Each direction vector identifies an orientation of the associated face relative to the axes of the 3D coordinate system as indicated by coordinate symbol 205. A face having a flat surface, for example, may have a direction vector that is normal to its flat surface. In the illustrated example, and as reflected in data table 207 (which may be saved in memory), face 1 has a direction vector (DV1) in the direction of the y-axis, face 2 has a direction vector (DV2) in the direction of the x-axis, face 3 has a direction vector (DV3) in the direction of the negative y-axis, face 4 has a direction vector (DV4) in the direction of the negative x-axis, face 5 has a direction vector (DV5) in the direction of the z-axis, face 6 has a direction vector (DV6) in the direction of the negative z-axis, and face 7 has a direction vector (along its axis) in the direction of the z-axis. The axes references here are based on the illustrated coordinate symbol 205, which may be displayed together with a graphic representation of the 3D shape in the graphics area of a CAD system's user interface. Notably, in a typical implementation, when a 3D shape, such as the one shown in FIG. 2, has been generated from a sketch, the 3D coordinate symbol for the 3D shape will correspond to, and align with, the 2D coordinate symbol from the graphics area where the sketch was created. This means that, in a typical implementation, two of the axes (e.g., x and y) of the 3D coordinate symbol 205 align with the same two axes (x and y) of the 2D coordinate symbol.

In addition to having an associated direction vector, each face in the illustrated shape 207 originated from a sketch element of sketch 107 and/or from a feature applied to the sketch 107. In a typical implementation, each face in the 3D shape 207 is assigned an indication as to where that face originated (e.g., from a particular one of the sketch elements in sketch 107) and/or how the face was created (e.g., by application of a feature, such as extrude). Data table 209 shows an example of this. According to the illustrated data table 209, face 1 of the 3D shape 207 originated from sketch element ID1 (in the sketch 107 of FIG. 1), face 2 of the 3D shape 207 originated from sketch element ID2 (in the sketch 107 of FIG. 1), face 3 of the 3D shape 207 originated from sketch element ID3 (in the sketch 107 of FIG. 1), face 4 of the 3D shape 207 originated from sketch element ID4 (in the sketch 107 of FIG. 1), and face 7 of the 3D shape 207 originated from sketch element ID5 (in the sketch 107 of FIG. 1). Additionally, as reflected in data table 209, all of the faces (1 through 7) of the 3D shape 207 were formed by an extrude process applied to the sketch 107 of FIG. 1.

In a typical implementation, the data in data table 209 would be stored in memory together with the 3D shape 207 itself, which may be displayed in a graphics areas of a CAD program's user interface.

In a typical implementation, the systems and techniques disclosed herein enable users to select certain dimensional information (e.g., dimensions and associated tolerances) applied to a sketch or a feature to be designated critical, designating the selected dimension information as critical, and then automatically integrating any dimensional information designated as critical, from the sketch directly into a corresponding 3D model for MBD. This typically simplifies the process of dimensioning a 3D model for MBD, making the process quicker, more accurate, more reliable, and easier, while reducing the opportunity for user error.

One challenge in implementing this automatic incorporation of critical dimensional information from a sketch into a 3D model for MBD, is that in a sketch environment, sketch entities are generally defined in terms of lines and arcs, whereas in a 3D modeling environment for MBD, shapes are defined in terms of faces and edges. Lines and arcs have no clear meaning in a 3D modeling for MBD environment of faces and edges. In a typical implementation, therefore, the systems and techniques disclosed herein provide a mapping functionality to map the selected critical dimensions to associated faces. The mapping essentially leverages the information discussed above that gets stored when creating sketches and applying features to the sketches, applying dimensional information, and creating 3D models based on the sketches. Ultimately, the systems and techniques disclosed herein produce fully semantic and graphical PMI on a 3D model for MBD based, at least in part, on critical dimensional information from a sketch or a feature.

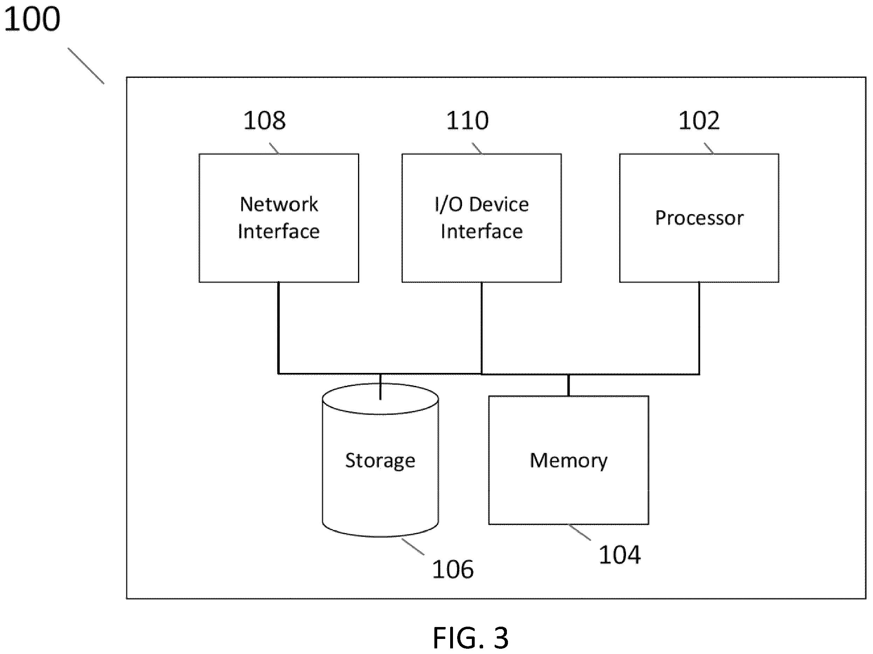

FIG. 3 is a schematic representation of an exemplary computer 100 configured to implement and/or facilitate the systems and techniques disclosed herein. More specifically, computer 100 is configured to facilitate the simple generation of accurate, highly detailed, and fully defined three dimensional (3D) model-based definition (MBD) representations of a real world object to be manufactured. In a typical implementation, the MBD representation of the real world object is derived from one or more sketches (e.g., 2D sketches) of the real world object and the computer 100 is configured to facilitate automatic incorporation of dimensional information designated as critical from the one or more sketches into the 3D model for MBD derived from the sketch(es).

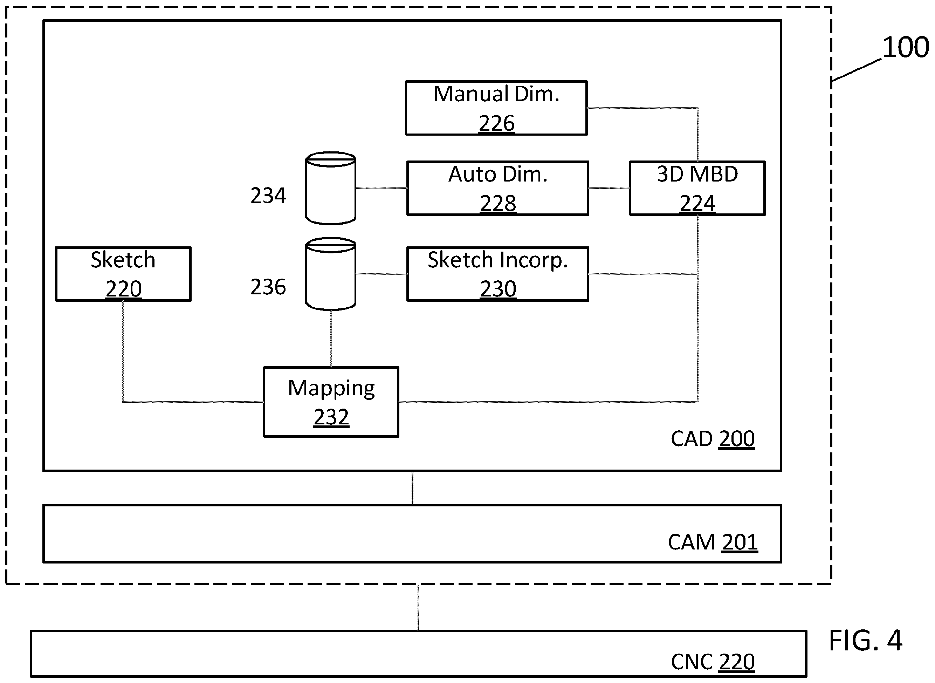

The dimensional information that gets automatically incorporated into the 3D MBD from the one or more sketches can include, for example, values for discrete physical dimensions and associated tolerances placed by a user into the one or more sketches and designated by the user, while creating the sketching and/or applying features, as critical. In a typical implementation, the computer 100 incorporates such critically designated dimensional information from the sketch into the 3D representation for MBD automatically (e.g., via 230, FIG. 4). In a typical implementation, the computer 100 enables the user to enter other product manufacturing information (PMI) into the 3D MBD model manually (e.g., via 226, FIG. 4) and/or is configured to annotate the 3D MBD model with dimensional information preprogrammed into a database (see, e.g., 234, FIG, 4) of default values for same, via an auto dimensioning tool (see, e.g., 228, FIG. 4).

In a typical implementation, the computer 100 provides a simple approach for creating reliable, and accurate way to reuse dimensional information present in sketches and features to create a 3D MBD representation of the sketched object with dimensional information and other PMI that is graphical and fully semantic. Graphical PMI is a type of PMI that is readable to human eyes, but not generally consumable by machines or software. Semantic PMI is a type of PMI that is not only human-readable but is also machine-readable. The PMI in the MBD representation, especially the critical dimensional information incorporated from the sketch, typically represents the full and true design intention, and can be used in manufacturing automation, for example, such as Computer-Aided Manufacturing (CAM) and Coordinate Measuring Machines (CMMs), performed by real world physical machines. Moreover, in a typical implementation, the PMI in a resulting 3D MBD model, including the dimensional information designated as critical that gets incorporated from a sketch as disclosed herein, has a degree of detail and precision that completely enables the manufacturing of a corresponding real world object represented by the 3D MBD model, in accordance with all applicable standards, including those promulgated by the National Institute for Standards and Technology (NIST), as an example.

In some implementations, the computer 100 includes a translator configured to export information, including the PMI, from the 3D model for MBD to a file format that is suitable for reading by a real world manufacturing machine (e.g., a CNC machine). For example, in some implementations, the file format is the STEP ("Standard for the Exchange of Product model data") file format, defined by the International Organization for Standardization (ISO) standard, ISO 10303, an international standard for computer-interpretable representation and exchange of PMI. ISO 10303 can be used to represent 3D objects in CAD and related information. STEP files, for example, can be read directly by certain real world machines (e.g., CNC machines) to perform manufacturing processes to manufacture a real world version of an object represented in the corresponding 3D MBD model. In such cases and others, the cumbersome, and potentially error prone step of creating multiple 2D engineering drawings from a 3D model can be avoided.

Referring again to FIG. 3, the computer 100 has a processor 102, computer-based memory 104, computer-based storage 106, a network interface 108, an input/output device interface 110, and a bus that serves as an interconnect between the components of the computer 100. The bus acts as a communication medium over which the various components of the computer 100 can communicate and interact with one another.

The processor 102 is configured to perform the various computer-based functionalities disclosed herein as well as other supporting functionalities not explicitly disclosed herein. Some such functionalities include facilitating the sketch and MBD-related functionalities disclosed herein. Typically, the processor 102, together with other computer components, performs these, and other, functionalities by executing computer-readable instructions stored on a computer-readable medium (e.g., in 104, 106, or elsewhere). In various implementations, some of these functionalities may be performed with reference to data stored in the computer-readable medium and/or received from some external source (e.g., an input / output (I/O) device via the I/O device interface 110 and/or from an external network via the network interface 108).

The computer 100 has volatile and non-volatile memory. More specifically, in a typical implementation, memory 104 provides a form of volatile storage storing computer-readable instructions that, when executed by the processor 102, cause the processor 102 to perform or facilitate performance of some (or all) of the computer-based functionalities disclosed herein. Moreover, in a typical implementation, storage 106 provides a form of non-volatile memory storing computer-readable instructions, such as instructions to implement an operating system, configuration information, etc. The various system memory resources (e.g., 104, 106) may store data to support computer functionalities disclosed herein and otherwise, as well.

In a typical implementation, memory 104 stores the computer-readable instructions that, when executed by the processor 102, cause the processor 102 to perform functionalities that present to a user at the computer 100 a computer-aided design program that incorporates and/or facilitates the functionalities disclosed herein, including those related to the automatic incorporation of dimensional information from one or more sketches into a corresponding 3D MBD drawing. Examples of computer-aided design platforms suitable for adapting to incorporate the functionalities disclosed herein is the SOLIDWORKS^{®} or CATIA^{®} computer programs, which are available from Dassault Systèmes Corporation, the applicant of the current application. The SOLIDWORKS^{®} program, for example, has a sketching tool as well as an MBD tool. Implementations of the computer-aided design program, so adapted, would include one or more (or all) the functionalities disclosed herein.

The network interface 108 is a component that enables the computer 100 to connect to any one or more of a variety of external computer-based communications networks, including, for example, local area networks (LANs), wide area networks (WANs), such as the Internet, or the like. In various implementations, the network interface 108 can be implemented in hardware, software, or a combination of hardware and software. In some implementations, the network interface (or other interface) may provide a connection to other external machinery (e.g., one or more CNC machines, etc.).

The input/output (I/O) device interface 110 is a component that enables the computer 100 to interface with any one or more input or output devices, such as a keyboard, mouse, display, microphone, speakers, printers, etc. In various implementations, the I/O device interface can be implemented in hardware, software, or a combination of hardware and software. In a typical implementation, the computer may include one or more I/O devices (*e.g.,* a computer screen, keyboard, mouse, printer, touch screen device, etc.) connected to the I/O device interface 110. These I/O devices (not shown in FIG. 3) act as human-machine-interfaces (HMIs) and are generally configured enable a human user to interact with the computer 100 to access and utilize functionalities, particularly those related to computer-aided design disclosed herein.

In an exemplary implementation, the computer 100 is connected to a display device (e.g., via the I/O device interface 110) and configured to present at the display device a visual representation of an interface to a product design environment, such as the one provided by and within the SOLIDWORKS^{®} computer program. The interface and its visual representation on the computer-based display device, in a typical implementation, provides the user with access to the functionalities disclosed herein, and displays (e.g., on a display device coupled to the I/O device interface 110) a visual representation of the 2D sketches, 3D models, drawings, screenshots, etc.

In some implementations, the computer 100 and its various components may be contained in a single housing (e.g., as in a personal laptop) or at a single workstation. In some implementations, the computer 100 and its various components may be distributed across multiple housings, perhaps in multiple locations across a network. Each component of the computer 100 may include multiple versions of that component, possibly working in concert, and those multiple versions may be in different physical locations and connected via a network. For example, processor 102 in FIG. 3 may represent multiple discrete processors in different physical locations working together to perform processes attributable to processor 102 in a coordinated manner. A wide variety of possibilities regarding specific physical implementations are possible.

In various implementations, the computer 100 may have additional elements not shown in FIG. 3. These can include, for example, controllers, buffers (caches), drivers, repeaters, receivers, a graphics processing unit (GPU), etc. Furthermore, the interfaces (e.g., 108, 110) may include elements not specifically represented in FIG. 3, including, for example, address, control, and/or data connections to facilitate communications between the illustrated computer components.

In various implementations, the computer 100 may host, not only a CAD (or other) program that includes the functionalities disclosed herein, but also may host other programs, such as CAM programs, that can be used in conjunction with the CAD program (e.g., to facilitate generating machine-readable instructions for an external CNC machine that get transmitted to an external CNC machine via the network interface 108, for example.

FIG. 4 is a schematic representation showing a CAD program 200 executing on the computer 100 with various functional components thereof, a computer-aided manufacturing (CAM) program 201 in the computer 100 and in functional communication with the CAD program, and a CNC machine 220 connected to and in functional communication with the computer 100 and the CAM program 201 in the computer 100. In short, the CAD program 200 enables users to create 3D models for MBD with fully semantic and graphical PMI based on sketches, efficiently, effectively, and accurately. The CAM program 201 provides output based on the 3D models for MBD and associated PMI directly to the CNC machine, which manufactures a real world object based on the 3D models for MBD utilizing the instructions provided by the CAM program 201.

The functional components in the illustrated computer 100 include a sketching tool 222, a 3D MBD tool 224, a manual dimensioning tool for MBD 226, an auto dimensioning tool for MBD 228, a sketch dimensional information incorporating tool 230, a mapping tool 232, an auto dimensioning tool database 234, and a critical sketch dimension database 236. In a typical implementation, each of the sketching tool 222, the 3D MBD tool 224, the manual dimensioning tool for MBD 226, the auto dimensioning tool for MBD 228, and the sketch dimensional information incorporating tool 230 is implemented using a processor (e.g., 102 in FIG. 3) executing computer readable instructions stored in computer readable media, such as memory 104 or 106 in FIG. 3. In an exemplary implementation, the auto dimensioning tool database 234, and the critical sketch dimension database 236 are stored in computer memory (e.g., 104 or 106 in FIG. 3). Some of the components of the CAD system 200 represented in FIG. 4 interact with other elements of the computer too. The sketching tool 222, for example, (and others) typically would interact with the computer display and/or one or more input/output devices.

In a typical implementation, the sketching tool 222 in the illustrated CAD program 200 enables users to produce one or more sketches, to apply features, and to add dimensional information (e.g., dimensions and tolerances) to the sketches / features. Additionally, in a typical implementation, the sketching tool 222 enables users to designate selected dimensional information as critical. The mapping tool 232, in a typical implementation, maps any dimensional information in a sketch designated as critical to a corresponding face of a related 3D model for MBD. The critical sketch dimension database 236, in a typical implementation, stores dimensional information (e.g., dimensions and/or tolerances, etc.) from particular sketches, where each item of stored dimensional information is from a particular sketch and is mapped to (or stored in logical association with) a face identifier for an associated face of a 3D model for MBD derived from the particular sketch. In a typical implementation, the sketch dimensional information incorporating tool 230 automatically applies user designated critical dimensional information from the critical dimension database 236, which originated in an associated sketch, to a corresponding face in a 3D model for MBD based on the associated face identifier in the critical sketch dimension database 236. The manual dimensioning tool 226 in a typical implementation enables users to manually enter dimensional information into the 3D model for MBD. The auto dimensioning tool database 234 in a typical implementation stores generic, preprogrammed dimensioning information (e.g., standard tolerances, etc.) that is not particular to specific sketch or model. The auto dimensioning tool 226 applies dimensional information to the 3D model for MBD from the auto dimensioning tool database 234.

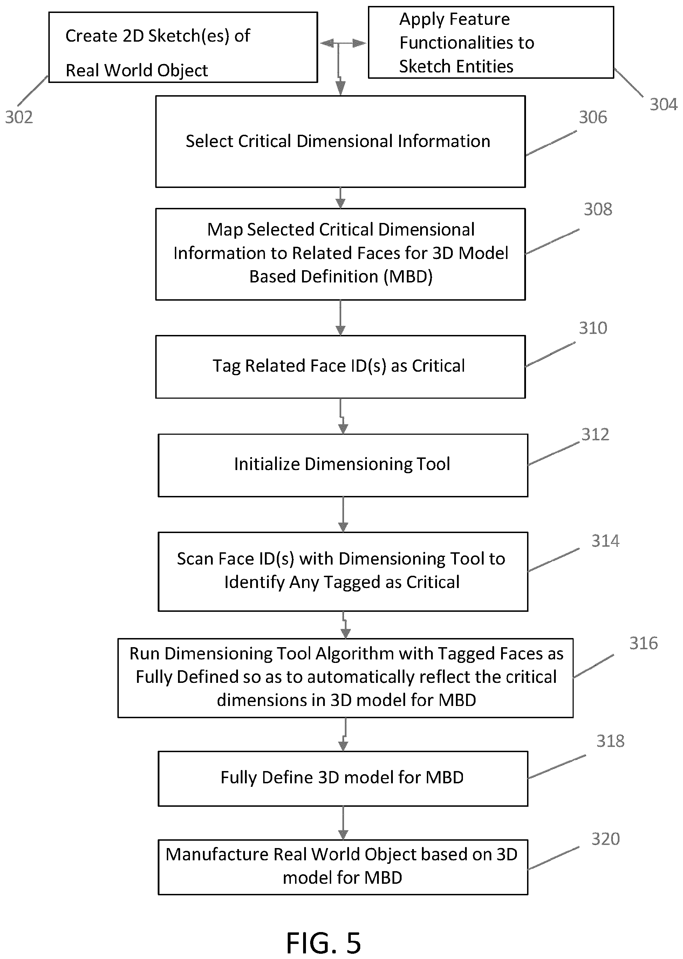

FIG. 5 is a flowchart representing a user's interactions with computer 100 to generate an accurate, highly detailed, and fully defined 3D MBD representation of a real world object to be manufactured and then manufacturing same with a real world manufacturing machine. The process represented by the illustrated flowchart includes the automatic incorporation of selected dimensional information designated as critical from one or more sketches of the real world object into a corresponding 3D model for MBD derived from the sketch(es).

First, according to the illustrated flowchart, the user (at 302) creates one or more 2D sketch(es) of the real world object to be manufactured. The sketch(es) may be produced using the sketching tool 220 and may include one or more views of the real world object. Where multiple views are produced, the multiple views may include views from different perspectives (e.g., on different planes in Euclidian space, e.g., on a x-y plane, on a y-z plane, and/or on an x-z plane, as defined by a Cartesian coordinate system). In a typical implementation, the user may create enough views to define the overall appearance of the object as intended by the user. The sketching tool may, in an exemplary implementation, be the sketch tool in the SOLIDWORKS^{®} computer program, and may facilitate creating the sketch(es), each of which includes one or more sketch entities (e.g., lines, arcs, etc.). Once created, the sketch(es) typically are stored in computer memory (e.g., 104 or 106 in FIG. 3), along with the sketch information detailed above and represented in FIG. 1.

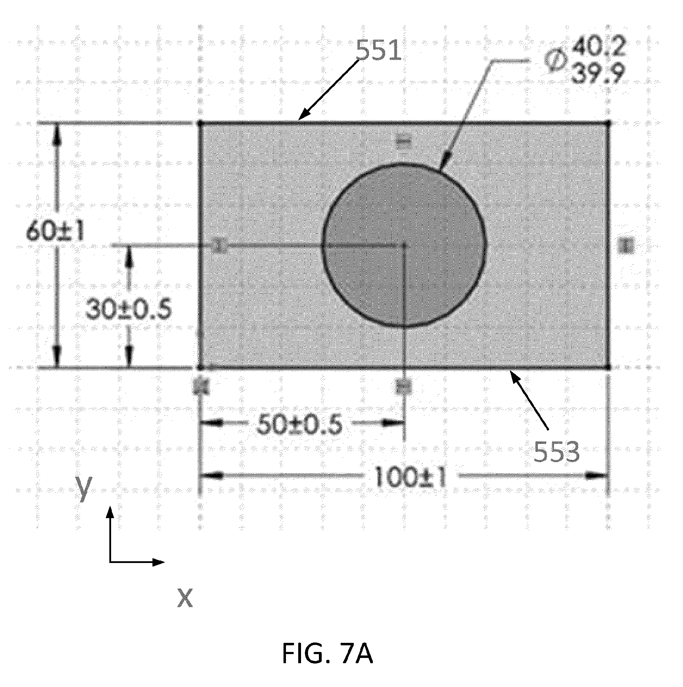

The user may, of course, apply dimensional information to the sketch(es). The dimensional information can include, for example, values for distance and size as well as associated tolerances. Since the sketch(es) are made up of sketch entities, the dimensional information applied to the sketch(es) typically references (and relates to) the sketch entities (e.g., lines, arcs, etc.) that make up the sketch entities. For example, if a particular sketch shows a rectangle with a circle inside the rectangle, the user may apply a dimension of 30 millimeters and a tolerance of +/-0.5 millimeters to a distance between a center point of the circle and a line on an edge of the rectangle to the circle's center point. An example of this is shown in FIG. 7A, which shows a sketch that may appear on a screenshot on the computer display. The sketch in the illustrated example, like the sketch in FIG. 1, has a rectangle and a circle inside the rectangle. The user, in the illustrated example, has added dimensional information identifying the distance and an associated tolerance between a center point of the circle and the closest point on the bottom edge of the rectangle to the circle's center point as 30 +/- 0.5. This dimensional information references (and relates to) the rectangle and the circle in the illustrated sketch. Other dimensional information may be added to the sketch(es) as well. This, too, is represented in FIG. 7A, which shows multiple other user-provided values for dimensional information (e.g., dimensions and associated tolerances) on the rectangle and on the circle. It is noted that the numbers provided to express dimensional information in FIGS. 5A through 5D are unitless. However, it is to be understood that these dimensions, in practice, would be associated with some unit of measurement (e.g., inches, millimeters, etc.).

Each value of dimensional information in FIG 7A references (and relates to) one or more sketch entities (e.g., lines, arcs) in the illustrated sketch. For example, the dimensional value of 30+/-0.5 references (and relates to) a center point of the circle and a line at the bottom of the rectangle, the dimensional value of 50+/-0.5 references (and relates to) the center point of the circle and a line on the left side of the rectangle, the dimensional value of 60+/-1 references (and relates to) a line at the top of the rectangle and the line at the bottom of the rectangle, the dimensional value of 100+/-1 references (and relates to) the line at the left side of the rectangle and a line at the right side of the rectangle, and, finally, the dimensional value of Φ 40.2 / 30.9 references (and relates to) the line that defines the circle. The dimensional value Φ40.2 / 30.9 in the illustrated example indicates references / related circle has a diameter between 30.9 [units] and 40.2 [units]. In an exemplary implementation, each of the dimensional values shown in FIG. 5A may be stored in computer memory (e.g., 104 or 106 in FIG. 3) in logical association with the lines, and/or arcs to which the dimensional value relates / references. Notably, the sketch entities and portions thereof (e.g., lines and/or arcs), to which the dimensional values relate / reference, exist in only sketch; they are not relevant in a 3D modelling environment.

The sketch shown in FIG. 7A is the type of sketch that may be used to begin generating a 3D model for MBD. As the user creates the sketch, the user may add various sketch entities and dimensional information to at least approximate the object being designed. At this point, the user may consider various dimensional information to be approximations, subject to change later on in the design process. However, some of the dimensional information being applied to the sketch at this point may be considered critical and intended to be fixed and to appear in final 3D model for MBD (i.e., not subject to change). A particular piece of dimensional information might be considered critical if, for example, it has a very small tolerance, or if it affects the fit of the object or a component within an assembly, or if its precise position affects the object's functionality, safety, or regulatory compliance, etc. In some instances, the user may consider all dimensional information to be critical. In a typical implementation, therefore, the computer 100 enables the user to designate the values and tolerances of certain dimensional information as critical so that, despite other changes to the design, any designated critical values will remain intact, and reliably and accurately represented in the design, and be carried automatically into a subsequent related 3D model for MBD.

Specifically, the process represented in the FIG. 3 flowchart includes a step 306 in which the user selects certain dimensional information in the sketch(es) to be designated as critical. There are a variety of ways in which the computer 100 may enable the user to select dimensional information to be designated critical. For example, in some implementations, the computer 100 may present on its display a user-selectable visual element, the selection of which causes the computer 100 to open a dialog box in the computer's user interface that enables the user to designate any critical dimensions. In some implementations, the computer 100 may automatically prompt the user to consider whether a dimensional information in the sketch should be designated critical when the user creates the dimensional information. Other implementations are possible as well.

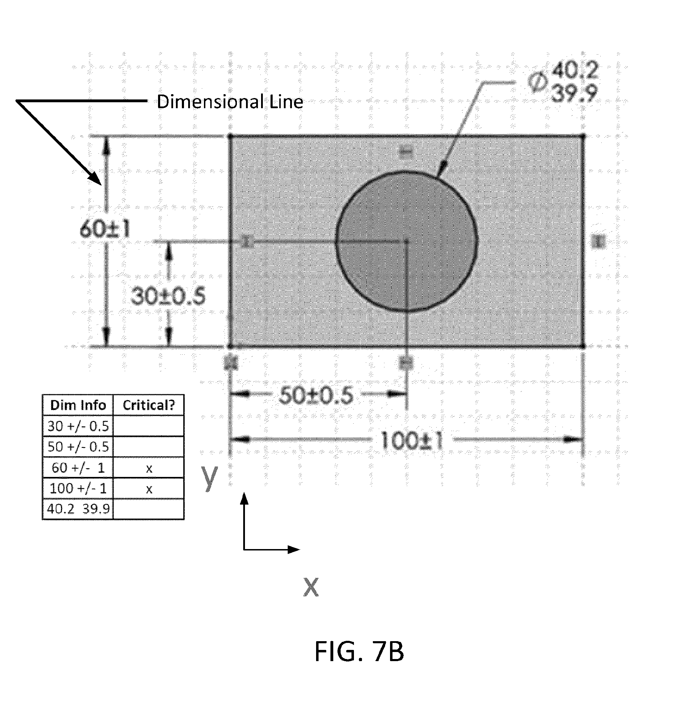

FIG. 7B is a schematic representation showing an example of a dialog box that may appear on the display to enable the user to identify any critical dimensions in the rectangle and circle sketch of FIG. 7A (which is also shown in FIG. 7B). The illustrated dialog box has two columns. The left column lists the values of dimensional information provided in the sketch. The right column provides user-selectable fields, the selection of which, causes the computer 100 to add an "x" to the column thereby indicating that the corresponding dimensional information has been selected for designation as critical, and to enter a designation in memory that the associated dimensional information value is to be treated as critical. As a result of being designated critical, the computer 100 will add corresponding dimensional information automatically to the 3D model for MBD developed from the associated sketch.

In the illustrated example, in FIG. 7B, the dimensional information 60 +/- 1 and 100 +/-1, which respectively correspond to the height and width of the rectangle, is shown as having been marked critical. In this example, the computer 100 would treat the so designated dimensional information as critical, and subsequently incorporate dimensions and tolerances based on the critical dimensional information automatically into a 3D model for MBD that is developed from the associated sketch. In some implementations, if a user attempts to override or change any dimensional information in the 3D model for MBD that was based on dimensional information designated as critical, then the computer 100 may block those changes from taking effect, or at least present a warning to the user that the dimensional information the user is attempting to change has been designated critical before permitting the user to override the warning.

The other dimensional information listed in the dialog box in FIG. 7B is not checked and, therefore, will not be treated as critical by the computer 100. This means that those values of dimensional information from the sketch will not be included automatically in a 3D model for MBD derived from the sketch. Instead, for dimensions and tolerances in the 3D model for MBD that correspond to the unchecked dimensions, the user creating the 3D model for MBD will be able to assign values using the manual dimensioning tool for MBD 226 or the auto dimensioning tool for MBD 228. Dimensional information can generally be entered in a 3D model for MBD with or without regard to the corresponding dimensional information provided in an originating sketch(es). Entering such dimensional information into the 3D MBD model manually can be more cumbersome and error prone than automatically populating the 3D MBD model with dimensions and tolerances based on dimensional information selected as critical in the originating sketch. Despite such risks, keeping the option of manual entry available beyond the sketch stage of design may, in some instances, be desirable because it keeps open the ability to easily modify a design, especially in minor or less impactful ways, as the design evolves. In a typical implementation, the systems and techniques disclosed herein strike a balance between easily producing detailed and accurate 3D models for MBD models from sketches, while also maintaining a reasonable amount of flexibility throughout the design process.

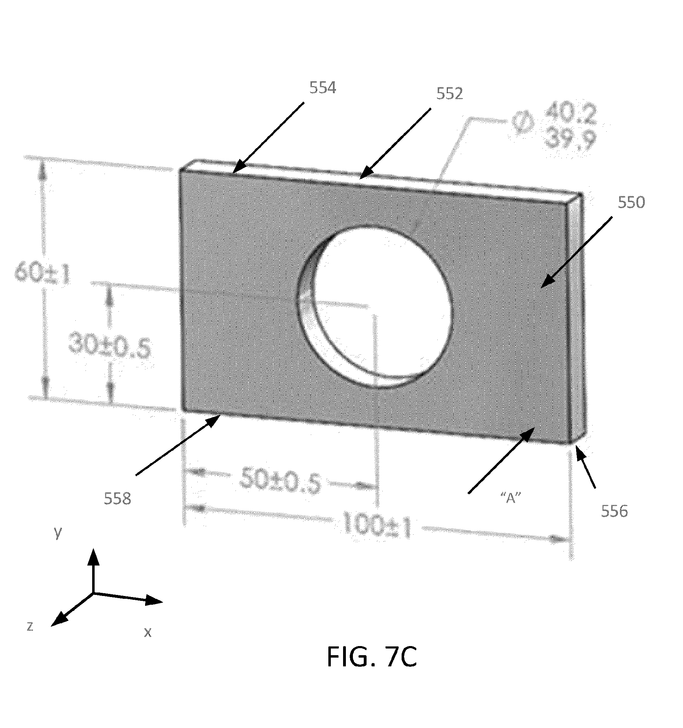

Referring again to the flowchart of FIG. 5, the process represented therein also includes applying one or more feature functionalities (at 304). These may include, for example, features like those available in the SOLIDWORKS software application, such as extrude, which may involve adding additional dimensions, and associated dimensional information to the design. FIG. 7C shows an example of a 3D version of the 2D sketch in FIG. 7A that may result from the application of an extrude feature to add material to the 2D sketch of FIG. 7A and extrude the 2D sketch a small distance along a straight line in a direction defined by arrow (A). This gives thickness, and therefore adds a third dimension, to the previously 2D shape. As shown, applying this feature functionality converts the sketched 2D rectangle with a circle in it into a 3D representation of a rectangular cuboid with a cylindrical feature (e.g., hole) passing through the rectangular cuboid. The rectangular cuboid in the 3D representation corresponds to the rectangle in the 2D sketch and the cylindrical hole in the 3D representation corresponds to the circle in the 2D sketch. The thickness of the rectangular cuboid (in the direction of arrow Y) depends on the amount of extruding that gets applied to the 2D sketch (in the direction of arrow Y).

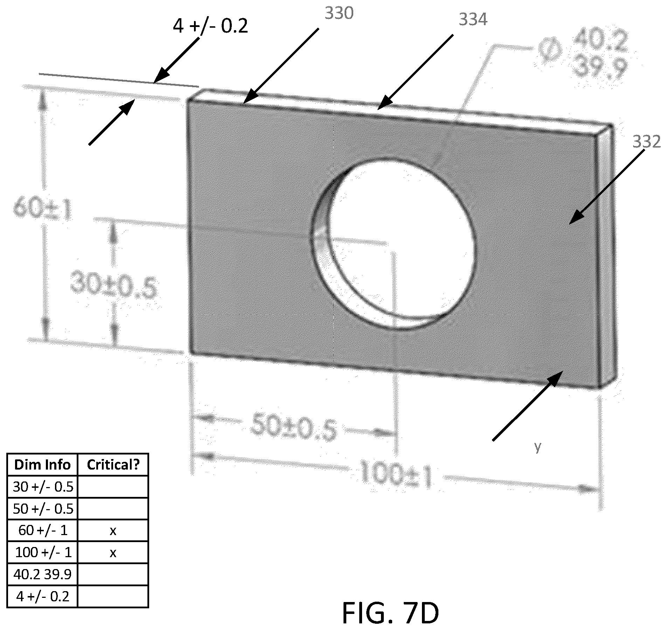

In a typical implementation, the computer 100 (again at 306) enables the user to designate any new dimensions (e.g., dimensions, such as thickness in the y direction that may have resulted from the application of one or more features) as critical. In this regard, the computer 100 may present on its display a dialog box like the one shown in FIG. 7B, populated with dimensional information that includes any newly added dimensional information and enables the user to select one or more of the dimensional information values, as above, for designation as critical. An example of this is shown in FIG. 7D. The dialog box in FIG. 7D includes all the dimensional information from the dialog box in FIG. 7B as well as the new thickness dimension (4 +/- 0.2) added as a result of the application of the extruded feature. Still, in the illustrated example, the only dimensions selected for designation as critical are the 60 +/- 1 and 100 +/- 1 dimensions.

No matter how the foregoing functionalities are implemented, the computer 100 is configured so as to enable the user (at 306) to select (i.e., identify to the computer 100) any dimensional information in a sketch that should be designated as critical, and the computer 100 is further configured to capture any such selected designations (e.g., by storing them in computer memory (e.g., 104 or 106 in FIG. 3)).

In essence, no matter how these steps (302, 304, 306) are implemented, the computer 100 enables users to add dimensional information to sketches and features and to designate any of that dimensional information as critical.

Next, in the flowchart of FIG. 5, the computer 100 (at 308) maps any dimensional information from the sketch / features that has been designated as critical to one or more associated faces for a corresponding 3D model for MBD. There are a variety of ways that this mapping process may be performed. Typically, however, the computer 100 leverage the information stored about the sketch, 3D shape, dimensional information, faces, etc. discussed above, to map the critical dimensions from the sketch to faces on the 3D model.

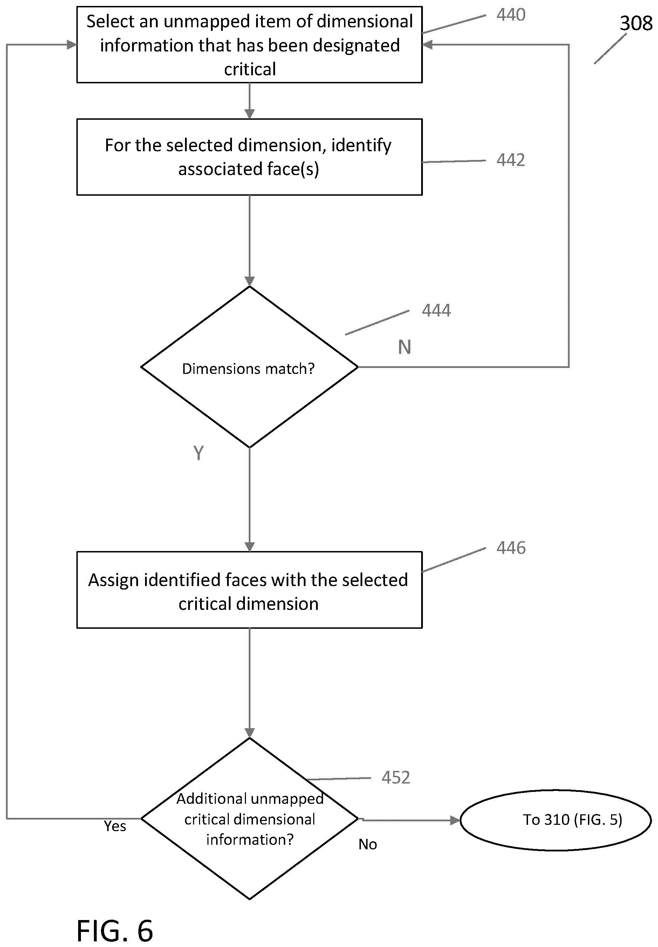

FIG. 6 is a flowchart that representing one possible way that the computer 100 may perform mapping process 308. Many variations and other approaches are possible as well. According to the illustrated flowchart, first, the computer 100 (at 440) selects one piece of dimensional information that has been designated critical.

In the example above, the computer 100 designated two pieces of dimensional information (60 +/- 1 and 100 +/- 1) as critical. Continuing this example, the computer 100 (at 440) selects, from computer memory, one of those pieces of dimensional information (e.g., 60 +/- 1) for the initial steps in the indicated mapping process.

Next, for the selected critical dimension (e.g., 60 +/- 1) from the sketch, the computer 100 (at 442) identifies faces on the 3D model (in FIG. 5C, for example) associated with the selected critical dimension. The computer 100 may do this by using the following exemplary process. First, the computer 100 may note the sketch element to which the dimensional information applies. For example, referring to FIG. 1, the dimensional information 60 +/- 1 relates to the sketch element having ID1 (which is the top line of the rectangle). Referring now to FIG. 2, the computer 100 may then note that face 1 originated at sketch element ID1. The computer 100 may then consider the direction vector of face 1 (DV1 = Y vector (0,1,0)), which means that a normal to face 1 extends in a positive direction along the y-axis. Therefore, the computer 100 concludes that face 1 faces upward. The computer 100 may then note the direction of the associated dimension (DIM2 is on the y-axis) and conclude that the opposite end of the dimensional line for the dimension should, therefore, be applied to a face that is in the downward (-y) direction, e.g., face 3.

Once the two faces (face 1 and face 3) have been identified, the computer 100 (at 444) may compare the associated dimensional value from the sketch to the actual distance between those faces in the 3D environment to confirm that the correct faces have been selected for applying DIM2 (60 +/- 1) to the 3D shape. If the comparison (at 444) confirms that the correct faces have been selected for applying DIM2 (60 +/- 1) to the 3D shape, then the computer 100 (at 446) assigns the dimension DIM2 to the identified faces (face 1 and face 3). If the comparison (at 444) reveals that the sketch dimension does not match the 3d shape dimension, then the computer 100 may discard the association between the identified dimension at issue and the identified faces and return to step 440 to continue the process with another item of dimensional information.

There may be other ways to leverage and/or process the data stored to determine which faces relate to a particular dimensions, but this is an example. For dimensions that reference the cylindrical hole in FIG. 7D, for example, the mapping process may be simpler, because there is only one hole in the 3D shape of FIG. 7D.

Next (at 452), the computer 100 considers whether there is any additional dimensional information that has been marked critical but not yet assigned to particular faces in the 3D shape. If there is any such additional dimensional information, then the computer 100 returns to 440 and selects one of the additional unassigned item of dimensional information for processing in accordance with the foregoing processing steps. Otherwise, the computer 100 returns to step 310 (in FIG. 5). Of note, in a typical implementation, the computer 100 (at 308) maps only dimensional information from the sketch that has been designated as critical. The computer 100 may not map any other dimensional information (e.g., not designated critical) at 308.

Referring again to the flowchart of FIG. 3, after mapping selected critical dimensional information to related faces in the 3D shape (at 308), the computer 100 (at 310) tags any of the related faces as critical. Typically, this entails the computer 100 storing a designation in association with corresponding face identifiers, in computer memory, indicating that the associated face is a critical one, and should be treated as such. The computer 100 applies any associated critical dimensional information automatically to the 3D model in logical associated with the corresponding faces.

Next, in accordance with the illustrated flowchart, the user (at 312) initiates a dimensioning tool in the CAD program on the computer 100. The dimensioning tool (at 314) scans the face identifiers stored in computer memory to identify any faces that have been tagged as critical. The dimensioning tool algorithm, which may include auto dimensioning and/or manual dimensioning of undefined but necessary dimensional information, is run (at 316) with any faces tagged as critical being treated as already fully defined. Since such faces are treated as already fully defined, the previously applied critical sketch dimensions remain associated with those faces and appear as annotations, available for accessing, in the 3D model for MBD. In a typical implementation, the dimensioning tool algorithm is run to fully define the 3D model for MBD (at 318), at which point, the resulting 3D model for MBD may have enough PMI to enable manufacturing, either automatically by a CNC machine for example or otherwise, based entirely on the 3D model for MBD and the PMI contained therein.

Finally (at 320), the process includes manufacturing a real world object based on the 3D model for MBD and the PMI contained therein, including any sketch dimensions that were designated critical and therefore automatically reflected in the 3D model for MBD. The manufacturing process (at 320) may include generating instructions for the CNC machine 220 with the CAM program 201 in the computer 100 based on the 3D model for MBD and associated PMI and then manufacturing the real world object with the CNC machine based on those instructions. Of course, alternatives are possible as well. For example, in some instances, a manufacturer may simply reference the 3D model for MBD to manufacture the real world object using non-CNC machines. Also, in some instances, the resulting 3D model for MBD may be used to create a set of traditional 2D engineering drawings to facilitate manufacturing of the real world object by a manufacturer. Of course, in some instances, the 3D model for MBD may be used for any one or more of a variety of other purposes.

In view of the foregoing, it can be seen that the systems and techniques disclosed herein facilitate leveraging sketch information, which is generally only readable by humans, into information that is readable by humans and CAM, for example, which can be leveraged to automate manufacturing. The overall design process is streamlined and simplified. Moreover, improved accuracy in design representation, reduction in human error, and other advantages can be realized. Essentially, implementations of the processes disclosed herein enable human users to identify to a dimensioning tool which sketch dimensional information is important and need to be constrained. This is different from having the dimensioning tool, for example, determine for itself, which dimensions in a design are to be constrained. The resulting 3D model MBD is fully semantic and graphical and reflects the try intent of the users designing the object.

A number of embodiments of the invention have been described. Nevertheless, it will be understood that various modifications may be made without departing from the spirit and scope of the invention.

For example, in various implementations, computer components disclosed herein (e.g., applications, design tools, etc.) can be implemented by one or more computer-based processors (referred to herein as a processor) executing computer-readable instructions stored on non-transitory computer-readable medium to perform the associated computer-based functionalities (e.g., the functionalities disclosed herein attributable to a computer). The one or more computer-based processors can be virtually any kind of computer-based processors and can be contained in one housing or distributed at different locations, and the non-transitory computer-readable medium can be or include any one or more of a variety of different computer-based hardware memory / storage devices either contained in one housing or distributed at different locations.

Certain functionalities are described herein as being accessible or activated by a user selecting an onscreen button or the like. This should be construed broadly to include any kind of visible, user-selectable element or other user interactive element.

The systems and techniques disclosed herein can be implemented in a number of different ways. In one exemplary implementation, the systems and techniques disclosed herein may be incorporated into the SOLIDWORKS^{®} computer program available from Dassault Systèmes Solidworks Corporation. **In** various implementations, the systems and techniques can be deployed otherwise.

Various aspects of the subject matter disclosed herein can be implemented in digital electronic circuitry, or in computer-based software, firmware, or hardware, including the structures disclosed in this specification and/or their structural equivalents, and/or in combinations thereof. In some embodiments, the subject matter disclosed herein can be implemented in one or more computer programs, that is, one or more modules of computer program instructions, encoded on computer storage medium for execution by, or to control the operation of, one or more data processing apparatuses (e.g., processors). Alternatively, or additionally, the program instructions can be encoded on an artificially generated propagated signal, for example, a machine-generated electrical, optical, or electromagnetic signal that is generated to encode information for transmission to suitable receiver apparatus for execution by a data processing apparatus. A computer storage medium can be, or can be included within, a computer-readable storage device, a computer-readable storage substrate, a random or serial access memory array or device, or a combination thereof. While a computer storage medium should not be considered to be solely a propagated signal, a computer storage medium may be a source or destination of computer program instructions encoded in an artificially generated propagated signal. The computer storage medium can also be, or be included in, one or more separate physical components or media, for example, multiple CDs, computer disks, and/or other storage devices.

Certain operations described in this specification (e.g., aspects of those attributable to a computer) can be implemented as operations performed by a data processing apparatus (e.g., a processor / specially programmed processor / computer) on data stored on one or more computer-readable storage devices or received from other sources, such as the computer system and/or network environment described herein. The term "processor" (or the like) encompasses all kinds of apparatus, devices, and machines for processing data, including by way of example a programmable processor, a computer, a system on a chip, or multiple ones, or combinations, of the foregoing. The apparatus can include special purpose logic circuitry, e.g., an FPGA (field programmable gate array) or an ASIC (application specific integrated circuit). The apparatus can also include, in addition to hardware, code that creates an execution environment for the computer program in question, for example, code that constitutes processor firmware, a protocol stack, a database management system, an operating system, a cross-platform runtime environment, a virtual machine, or a combination of one or more of them. The apparatus and execution environment can realize various different computing model infrastructures, such as web services, distributed computing, and grid computing infrastructures.

While this specification contains many specific implementation details, these should not be construed as limitations on the scope of any inventions or of what may be claimed, but rather as descriptions of features specific to particular embodiments of particular inventions. Certain features that are described in this specification in the context of separate embodiments can also be implemented in combination in a single embodiment. Conversely, various features that are described in the context of a single embodiment can also be implemented in multiple embodiments separately or in any suitable subcombination. Moreover, although features may be described above as acting in certain combinations and even initially claimed as such, one or more features from a claimed combination can in some cases be excised from the combination, and the claimed combination may be directed to a subcombination or variation of a subcombination.

Similarly, while operations may be described herein as occurring in a particular order or manner, this should not be understood as requiring that such operations be performed in the particular order shown or in sequential order, or that all illustrated operations be performed, to achieve desirable results. In certain circumstances, multitasking and parallel processing may be advantageous. Moreover, the separation of various system components in the embodiments described above should not be understood as requiring such separation in all embodiments, and it should be understood that the described program components and systems can generally be integrated together in a single software product or packaged into multiple software products.

Other implementations are within the scope of the claims.

## Claims

1. A computer-based method of automatically creating one or more model-based definition (MBD) dimensions for a three-dimensional (3D) model for MBD based on one or more sketch dimensions, the method comprising:
enabling a user to select dimensional information from a sketch or feature to be designated as critical;
designating the selected dimensional information from the sketch as critical sketch dimensional information;
mapping the critical sketch dimensional information to related faces of a 3D shape derived from the sketch and feature; and
executing a dimensioning tool to annotate other portions of the 3D model with product manufacturing information (PMI) while automatically incorporating the critical dimensional information to the related face on the 3D shape.

2. The computer-based method of claim 1, wherein the automatic incorporation of the critical sketch dimensional information causes the 3D shape to be viewable with an annotation associated with the related faces that reflects the automatically incorporated critical dimensional information.

3. The computer-based method of claim 1, wherein mapping the critical sketch dimensional information comprises:
identifying multiple faces that relate to the selected dimensional information;
identifying a single face among the multiple faces based on contextual information; and
associating the single face with the selected dimensional information.

4. The computer-based method of claim 1, wherein mapping the critical sketch dimensional information comprises:
identifying a sketch element to which the critical sketch dimensional information applies; and
identifying a face in the three dimensional model that originated at the identified sketch element.

5. The computer-based method of claim 4, further comprising:
identifying a direction vector of the identified face; and
identifying a direction of the critical sketch dimensional information.

6. The computer-based method of claim 5, further comprising:
identifying the faces associated with critical sketch dimensional information based on the identified sketch element, the identified face that originated at the identified sketch element, the identified direction vector, and the direction of the critical sketch dimension.

7. The computer-based method of claim 6, further comprising:
comparing the critical dimensional information to a distance between the identified faces to confirm that the correct faces have been selected for applying the critical dimensional information to the 3D shape.

8. The computer-based method of claim 1, further comprising:
presenting the user with an option to annotate the other portions of the 3D model either manually or with an auto dimensioning tool.

9. The computer-based method of claim 1, further comprising:
tagging a face identifier of the related faces of the 3D model as critical;
scanning a list of face identifiers, including the tagged face identifier, for any face identifiers that have been tagged as critical; and
executing the dimensioning tool with the faces whose face identifiers have been tagged as critical being treated as already fully defined so that the critical sketch dimensional information remains associated with those faces and appears as annotations, available for accessing, in a resulting 3D model for MBD.

10. The computer-based method of claim 1, wherein the dimensioning tool is executed to fully define the 3D model for MBD, at which point, the 3D model for MBD has PMI to fully enable manufacturing based entirely on the 3D model for MBD and the PMI contained therein.

11. The computer-based method of claim 1, wherein the dimensional information from the sketch is selected from the group consisting of a dimension or a dimension and a tolerance, and wherein the dimensional information applies to either a sketch element or a feature applied to the sketch.

12. The computer-based method of claim 1, further comprising:
outputting a file based on the 3D model for MBD to a real-world machine for automated manufacturing of the product represented by the 3D model for MBD; and
manufacturing the product with the real-world machine.

13. A computer program for automatically creating one or more model-based definition (MBD) dimensions for a three-dimensional (3D) model for MBD based on one or more sketch dimensions, the computer program comprising instructions which, when executed by a computer system, cause the computer system to perform the method according to any one of Claims 1 to 12.

14. A system comprising:
a computer system comprising:
a computer processor; and
computer-based memory operatively coupled to the computer processor, wherein the computer-based memory stores the computer program of Claim 13.

15. A non-transitory computer readable medium having stored thereon the computer program of Claim 13.
